Europäisches Patentamt

European Patent Office

Office européen des brevets

(19)

(11) EP 0 678 948 B1

(12) FASCICULE DE BREVET EUROPEEN

(45) Date de publication et mention
de la délivrance du brevet:
**03.06.1998 Bulletin 1998/23**

(51) Int Cl.⁶: **H02B 1/20**, H01L 23/525

(21) Numéro de dépôt: 95400856.1

(22) Date de dépôt: 14.04.1995

(54) **Matrice de connexion configurable électriquement entre lignes d'au moins un port d'entrée-sortie de signaux électriques**

Elektrisch konfigurierbare Matrix für Verbindungen zwischen Leitungen mit mindestens einem Ein/Ausgangstor für elektrische Signale

Electrically configurable matrix for connection between lines with at least one input/output front for electrical signals

(84) Etats contractants désignés:
**AT BE CH DE DK ES FR GB GR IE IT LI LU MC NL PT SE**

(30) Priorité: **18.04.1994 FR 9404598**

(43) Date de publication de la demande:
**25.10.1995 Bulletin 1995/43**

(73) Titulaire: **TRANSPAC**
**75755 Paris Cédex 15 (FR)**

(72) Inventeur: **Chouteau, Philippe**
**F-35200 Rennes (FR)**

(74) Mandataire: **Fréchède, Michel et al**
**Cabinet Plasseraud**
**84, rue d'Amsterdam**
**F-75440 Paris Cédex 09 (FR)**

(56) Documents cités:
EP-A- 0 339 534         DE-A- 2 903 000
US-A- 3 423 646         US-A- 4 004 261
US-A- 4 823 320         US-A- 5 264 729
US-A- 5 321 322

• ELECTRO '87 & MINI/MICRO NORTHEAST, PAPER 36/1, vol.12, 1987, LOS ANGELES US pages 1 - 7, XP97050 R.R. JOHNSON 'Silicon Interconnect Technology'
• IEEE INTERNATIONAL SOLID STATE CIRCUITS CONFERENCE, vol.28, 15 Février 1985, NEW YORK US pages 268 - 269 H. STOPPER 'A Wafer with Electrically Programmable Interconnections'

## Description

L'invention concerne une matrice de connexion configurable électriquement entre lignes d'au moins un port d'entrée/sortie à N broches de connexion.

Dans le domaine technique de la transmission de données, l'interconnexion d'équipements hétérogènes est, entre autre, réalisée au moyen de câbles qui assurent la transmission des signaux numériques.

En raison de la grande diversité de ces équipements, bien que les circuits interfaces d'interconnexion entre ceux-ci soient normalisés, il est très souvent nécessaire d'effectuer des bouclages et des croisements de signaux pour mettre en oeuvre ces liaisons.

La spécificité de chaque interconnexion entre deux équipements entraîne donc la mise en oeuvre d'un grand nombre de câbles, dont la gestion est complexe.

A l'heure actuelle, différents types de matrices de connexion configurables électriquement ont été mis en oeuvre, essentiellement dans le domaine des circuits intégrés.

Parmi ceux-ci, le document IEEE International Solid State Circuits Conference, Vol.28, 15 février 1985, New-York, p.268-269 publié par H.STOPPER "A wafer with electrically programmable interconnectors" décrit un tel dispositif, réalisé sous forme de circuit intégré. Ce dispositif, outre la nécessité de quatre niveaux de métallisation, présente les inconvénients majeurs suivants. Du fait de la mise en oeuvre de connexions programmables à l'état initial ouvert, la commutation de celles-ci à l'état conducteur rend les différentes lignes électriques de plus en plus dépendantes d'une commande par impulsion de tension de programmation. Il est en conséquence nécessaire de prévoir des lignes spécifiques, de façon qu'une seule connexion programmable par ligne d'alimentation soit commutée.

Un tel dispositif est donc très complexe et permet, au plus, une configuration par adressage spécifique.

Un autre type de matrice programmable a été décrit par la demande de brevet EP 0 339 534, sous forme d'une structure de circuit intégré dans laquelle de nombreux points fusibles sont introduits, afin de permettre d'établir par adressage spécifique différentes configurations de données. En particulier, le motif de base de cette structure comprend dans une direction Nord-Sud des paires de lignes électriques, les lignes électriques dans la direction Est-Ouest pouvant être configurées par un fusible situé entre ces paires de lignes, une ligne Est-Ouest étant reliée par fusible aux deux lignes de chaque paire de lignes Nord-Sud. Cette structure, très complexe, est avant tout utilisée pour obtenir des réseaux de dispositifs à semi-conducteurs très diversifiés.

La présente invention a pour but de remédier aux inconvénients précités par la mise en oeuvre d'une matrice de connexion configurable électriquement entre lignes d'au moins un port d'entrée/sortie à N broches de connexion afin notamment, à partir d'un type d'interconnexion de structure donnée, de limiter le nombre de câbles nécessaires à la réalisation d'une configuration donnée, cette configuration pouvant être alors réalisée non plus par le choix de câbles d'interconnexion spécifiques, mais, au contraire, au niveau de chaque matrice de connexion.

La matrice de connexion configurable électriquement entre lignes d'au moins un port d'entrée/sortie à N broches, objet de la présente invention, est caractérisée en ce qu'elle comprend un support diélectrique sur lequel une pluralité de N lignes électriques distinctes, formant un premier réseau, sont prévues, chaque ligne électrique de ce réseau étant connectée à une broche du port d'entrée/sortie. Une pluralité de N lignes électriques distinctes formant un deuxième réseau, distinct du premier, est prévue, chaque ligne électrique de rang k du premier réseau, tel que $k \in [0, N-1]$, étant électriquement connectée par une connexion électrique permanente à la ligne électrique de même rang k appartenant au deuxième réseau.

Chaque ligne électrique de rang $q \neq k$ appartenant au premier réseau est électriquement connectée par une connexion électrique configurable à l'état de conduction ou de non-conduction à la ligne électrique de rang k appartenant au deuxième réseau.

Ceci permet, par commande de maintien de l'état de conduction ou de passage à l'état de non-conduction d'une pluralité des connexions électriques configurables, d'assurer la liaison électrique entre deux lignes électriques adjacentes ou non du premier réseau.

La matrice de connexion configurable électriquement entre lignes d'au moins un port d'entrée/sortie de signaux électriques trouve son application à l'informatique et aux télécommunications pour la réalisation de configurations d'installations de traitement et/ou de transmission de données numériques.

L'invention concerne également un procédé de configuration programmée de ladite matrice de connexion configurable conforme à la revendication 15 ainsi qu'un dispositif de configuration programmée de ladite matrice de connexion configurable conforme à la revendication 17.

Une description plus détaillée d'une matrice de connexion conforme à l'objet de la présente invention sera donnée ci-après, en référence aux dessins dans lesquels :

- la figure 1 représente une vue générale d'une matrice de connexion configurable électriquement entre lignes d'au moins un port d'entrée/sortie de signaux électriques, conforme à l'objet de la présente invention,
- la figure 2a représente une vue générale d'une variante de réalisation de la matrice de connexion objet de la présente invention représentée en figure 1,
- la figure 2b représente une vue générale d'une autre variante de réalisation de la matrice de connexion objet de la présente invention, dans laquelle une partition des lignes électriques en groupes de lignes électriques est réalisée, chaque groupe de lignes électriques étant relié à un port d'entrée/sortie distinct,

- la figure 3a représente un mode de réalisation particulier d'une matrice de connexion objet de la présente invention susceptible d'être utilisé dans le cas du mode de réalisation de la figure 1, 2a ou 2b,

- la figure 3b représente un détail de réalisation de la figure 3a dans une variante particulière,

- la figure 3c représente en vue de dessus un mode de réalisation particulier de la figure 3a, dans le cas où la matrice de connexion, objet de l'invention, est réalisée sous forme de circuit intégré, la couche de passivation étant supprimée afin de mettre à nu un niveau de métallisation supérieur,

- la figure 3d représente une vue en coupe selon un plan de coupe AA de la figure 3c,

- la figure 3e représente un autre mode de réalisation particulier d'une matrice de connexion objet de la présente invention, également susceptible d'être utilisé dans le cas du mode de réalisation de la figure 1, 2a ou 2b,

- la figure 4 représente un schéma illustratif d'un mode opératoire permettant la configuration électrique programmable d'une matrice de connexion objet de la présente invention,

- la figure 5 représente, à titre d'exemple, un programmateur plus particulièrement adapté pour réaliser la configuration d'une matrice de connexion objet de la présente invention,

- les figures 6a et 6b représentent une variante de réalisation de la matrice de connexion configurable électriquement, objet de la présente invention, dans laquelle le nombre de connexions configurables électriquement est optimisé,

- les figures 6c et 6d représentent une variante de réalisation des figures 6a et 6b dans le cas plus spécifique où la matrice de connexion configurable est réalisée sous forme de circuit intégré,

- les figures 7a, 7b et 7c sont relatives à un procédé de configuration programmé d'une matrice de connexion configurable électriquement par définition dans l'un des réseaux d'ensembles et sous-ensembles équipotentiels,

- la figure 8a représente un schéma synoptique illustratif d'un dispositif spécialement adapté pour la mise en oeuvre du procédé de configuration programmée par la méthode des ensembles et sous-ensembles équipotentiels,

- la figure 8b représente un mode de réalisation particulier avantageux d'un dispositif permettant la mise en oeuvre d'une configuration programmée, soit par adressage, soit par la méthode des ensembles et sous-ensembles équipotentiels, plus particulièrement destiné à être utilisé dans le cas d'une matrice de connexion programmable réalisée selon les figures 6c et 6d sous forme de circuit intégré.

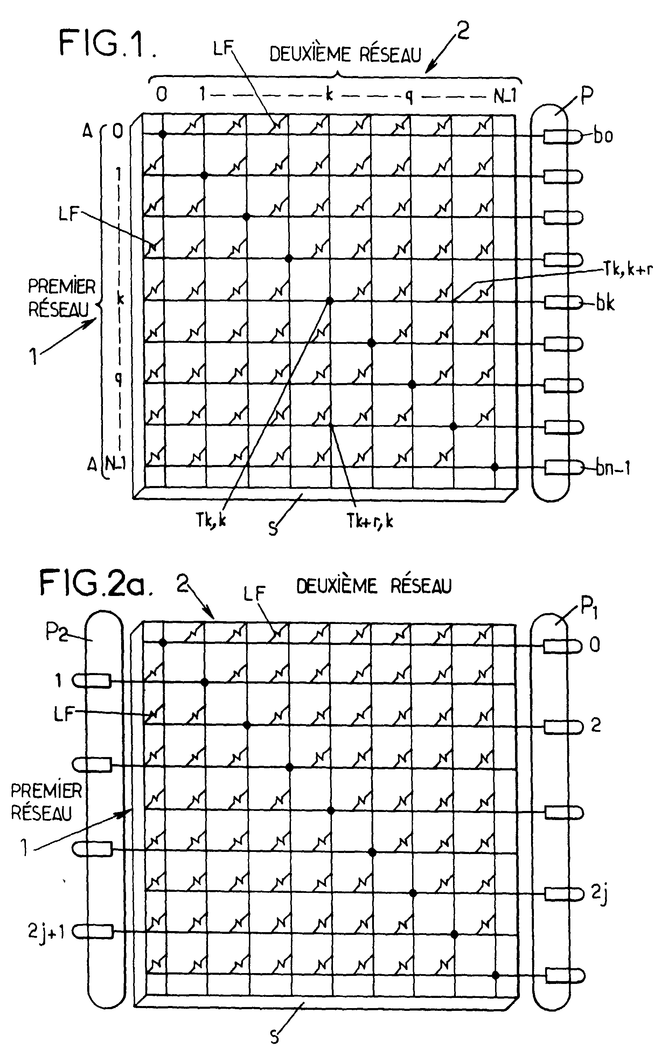

Une description plus détaillée d'une matrice de connexion configurable électriquement entre lignes d'au moins un port d'entrée/sortie conforme à l'objet de la présente invention sera maintenant décrite en liaison avec la figure 1.

Sur la figure précitée, on indique que la matrice de connexion selon l'invention comprend un support diélectrique S et, sur ce support, une pluralité de N lignes électriques distinctes formant un premier réseau, noté 1, de lignes électriques.

Chaque ligne électrique de ce premier réseau est connectée à une broche d'un port d'entrée/sortie, noté P, chaque broche étant notée $b_0$ à $b_{N-1}$.

Selon un autre aspect particulièrement avantageux de la matrice de connexion objet de la présente invention, celle-ci comprend une pluralité de N lignes électriques distinctes formant un deuxième réseau, noté 2, distinct du premier réseau 1. Chaque ligne électrique de rang k, le rang k étant compris entre [0, N-1] appartenant au premier réseau est électriquement connectée par une connexion électrique permanente, représentée par un point, à la ligne électrique de même rang k appartenant au deuxième réseau 2.

Chaque ligne électrique de rang q ≠ k du premier réseau 1 est électriquement connectée par une connexion électrique configurable à l'état de conduction ou de non-conduction électrique à la ligne électrique de rang k appartenant au deuxième réseau 2. Sur la figure 1, on indique que chaque connexion électrique configurable est représentée par une ligne brisée symbolisant une liaison fusible ainsi qu'il sera décrit ultérieurement dans la description.

On comprend que la structure de la matrice de connexion objet de la présente invention permet ainsi, par commande de maintien de l'état de conduction ou de passage à l'état de non-conduction d'une pluralité des connexions électriques configurables, d'assurer la liaison électrique entre deux lignes électriques adjacentes ou non du premier réseau 1.

D'une manière générale, on indique que les lignes électriques du premier respectivement du deuxième réseau 1, 2 sont sensiblement parallèles entre elles. Les lignes électriques du premier réseau sont orientées dans une première direction et les lignes électriques du deuxième réseau sont orientées dans une deuxième direction, transversale à la première. De préférence, les directions précitées sont perpendiculaires et chaque ligne du premier et du deuxième réseau 1, 2 est repérée par son rang, noté k, k+r pair ou impair, avec k ∈ [0, N-1], la valeur de r ≠ 0 ∈ [1-N, N-1].

Selon un aspect particulièrement avantageux de la matrice de connexion objet de la présente invention, on indique que la connexion électrique entre deux lignes de rang k et k+r adjacentes ou non du premier réseau est obtenue lorsque la relation logique :

Ak.Ak+r SI Tk,k ET Tk+r,k OU Tk,k+r ET Tk+r,k+r
est vérifiée.

Dans la relation logique précitée, on indique que le produit Ak.Ak+r désigne la valeur logique vraie d'interconnexion des lignes A de rang k respectivement k+r du premier réseau 1 et le premier respectivement le deuxième indice désigne le rang des lignes du premier respectivement du deuxième réseau. Les symboles SI, OU, ET désignent les opérateurs logiques correspondants, condition, union, intersection.

Tk,k et Tk+r,k+r désigne la valeur logique vraie de la connexion électrique permanente d'adresse k,k respectivement k+r,k+r entre lignes électriques de même rang du premier et du deuxième réseau.

Tk,k+r et Tk+r,k désigne la valeur logique vraie de l'état de conduction des connexions électriques configurables d'adresses correspondantes k,k+r et k+r,k entre lignes électriques du premier respectivement du deuxième réseau, toutes les autres connexions électriques configurables connectées aux lignes électriques interconnectées de rang k,k+r du premier réseau étant à la valeur logique complémentée de l'état de non-conduction pour une interconnexion des seules lignes de rang k,k+r du premier réseau.

En ce qui concerne la réalisation pratique de la matrice d'interconnexion objet de la présente invention, on indique que celle-ci peut être réalisée sur un circuit imprimé de faibles dimensions, par exemple.

D'une manière générale, on indique que toutes les lignes de la matrice de connexion du premier réseau peuvent être reliées à une broche du port d'entrée/sortie P.

La matrice de connexion selon l'invention peut alors être avantageusement enfermée dans un boîtier de type métallique, le tout étant blindé et rendu étanche aux perturbations électromagnétiques émises et/ou reçues.

Dans un premier mode de réalisation avantageux tel que représenté en figure 2a, on indique que les lignes électriques sont formées par des lignes à ruban ou lignes micro-bandes sensiblement rectilignes. Les lignes électriques de rang pair k = 2j du premier réseau 1 sont reliées à une de leurs extrémités à un premier port d'entrée/sortie, noté P1, et les lignes électriques de rang impair k = 2j+1 du même premier réseau 1 sont reliées à l'autre de leurs extrémités à un deuxième port d'entrée/sortie, noté P2. Les broches de connexion de chaque port d'entrée/sortie P1 et P2 sont notées respectivement $b_0$ à $b_{2j}$, $b_1$ à $b_{2j+1}$.

Dans un deuxième mode de réalisation, tel que représenté en figure 2b, les lignes à ruban ou lignes micro-bandes sont subdivisées en groupes de lignes électriques interconnectées ou non selon une configuration spécifique de chaque groupe. Les lignes électriques de chaque groupe sont interconnectées à un port d'entrée/sortie distinct, noté $P_1$ à $P_3$ sur la figure précitée. On comprend ainsi que la matrice de connexion objet de la présente invention permet de réaliser une partition d'un faisceau de lignes électriques pour réaliser, par exemple, une duplication d'une ligne de type BUS.

D'une manière générale, on indique que les lignes à ruban ou micro-bandes précitées sont formées sur un support diélectrique du type plaquette de circuit imprimé, substrat céramique ou silicium.

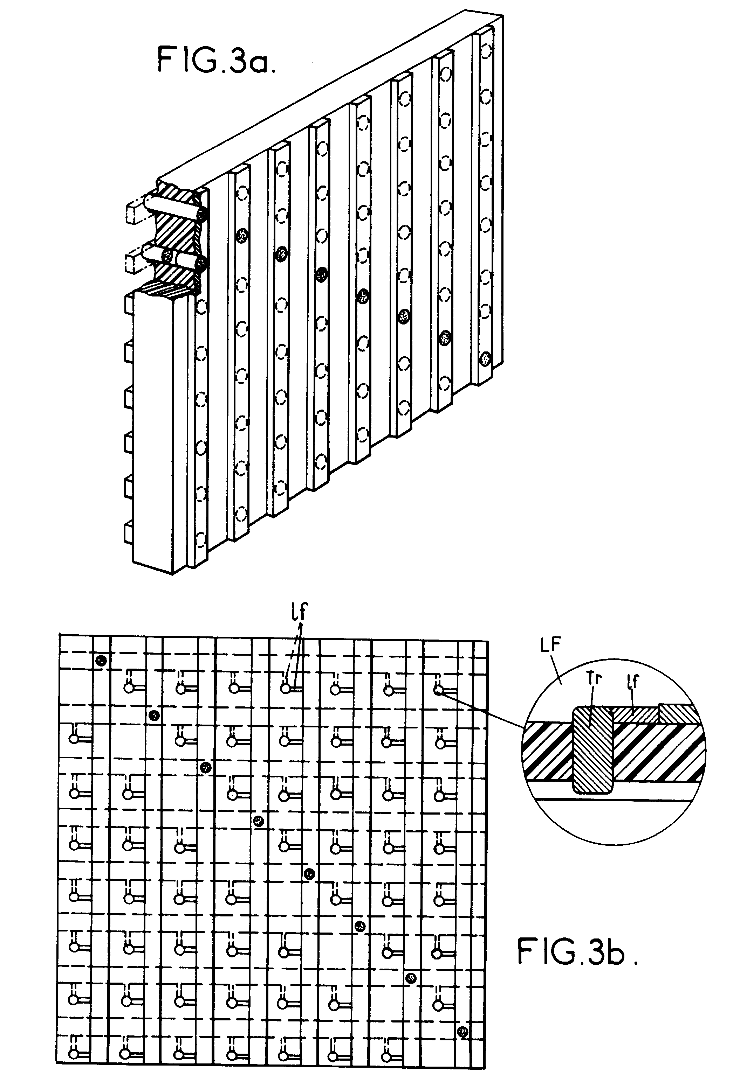

Lorsque le support diélectrique est un support de type plaquette de circuit imprimé, celui-ci peut avantageusement consister en un circuit imprimé double-face. Un tel circuit est représenté en figure 3a.

Les lignes électriques horizontales sont alors constituées de pistes de largeur telle que celles-ci sont susceptibles de supporter un courant égal à Imax > Ip > In en régime continu et impulsionnel où In désigne une valeur nominale d'intensité de courant, Ip désignant le courant nécessaire pour réaliser la programmation. Les lignes électriques précitées sont situées par exemple au côté soudure du circuit imprimé.

Les lignes verticales sont constituées par des pistes de même largeur que les lignes horizontales, lesquelles sont situées du côté composants du circuit imprimé par exemple.

Les connexions permanentes entre une piste horizontale et une piste verticale d'un même port sont réalisées par l'intermédiaire d'un trou traversant, lequel est muni d'une métallisation permanente.

Les liaisons configurables, notées LF, peuvent alors être réalisées par des traces conductrices, notées lf, les changements de face étant réalisés par l'intermédiaire d'un trou métallisé Tr par exemple, ainsi que représenté selon un mode de réalisation avantageux en figure 3b, l'ensemble constituant la liaison configurable LF.

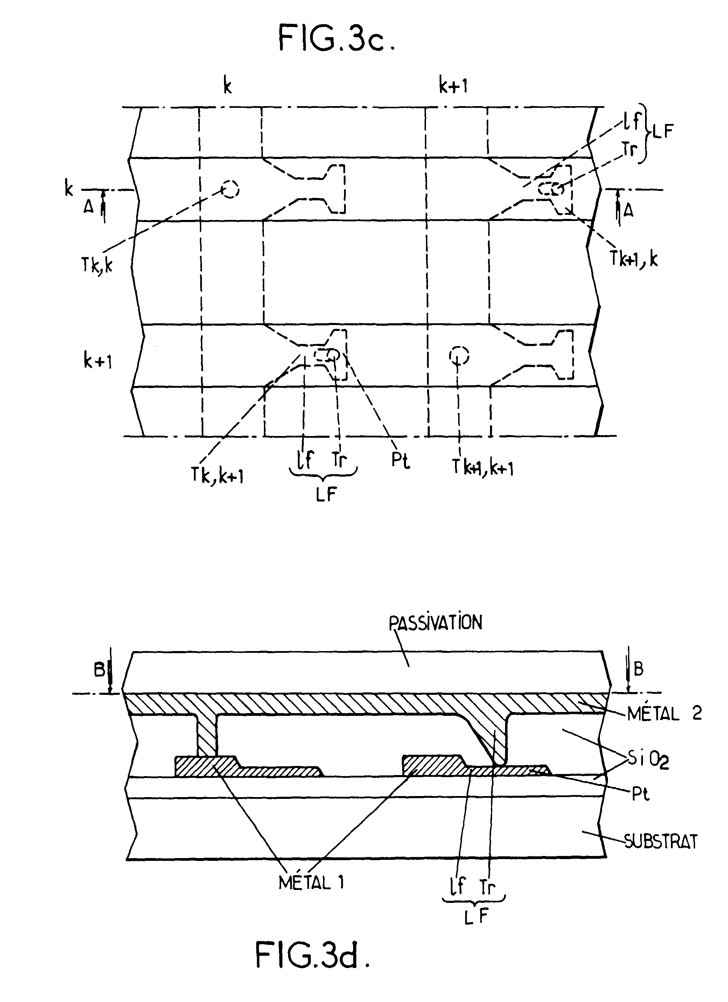

Dans une variante de réalisation telle que représentée en figure 3c et 3d, la matrice de connexion, objet de l'invention, peut être réalisée sous forme de circuit intégré. Le support diélectrique est remplacé par un substrat de silicium comportant un premier niveau de métallisation, référencé métal 1, et un deuxième niveau de métallisation, référencé métal 2, chacun des niveaux de métallisation constituant le premier respectivement le deuxième réseau de N lignes électriques. Les connexions électriques permanentes Tk,k peuvent être réalisées par un trou traversant métallisé, assurant le contact électrique entre premier et deuxième niveau de métallisation et les connexions électriques configurables Tk,k+r ou liaisons fusibles LF peuvent, de façon semblable au mode de réalisation de la figure 3b, être réalisées par un trou traversant Tr métallisé permettant d'assurer le contact électrique, par exemple, entre le deuxième niveau de métallisation et un plot Pt électriquement conducteur relié aux lignes électriques formant le deuxième réseau par une connexion fusible lf. Chaque plot Pt connexion fusible lf et trou traversant métallisé Tr constitue une liaison fusible LF.

Les étapes permettant de réaliser la matrice de connexion telle que représentée en figure 3c et 3d peuvent alors consister, à partir d'un substrat de silicium dopé de type N ou P, en des opérations de type classique.

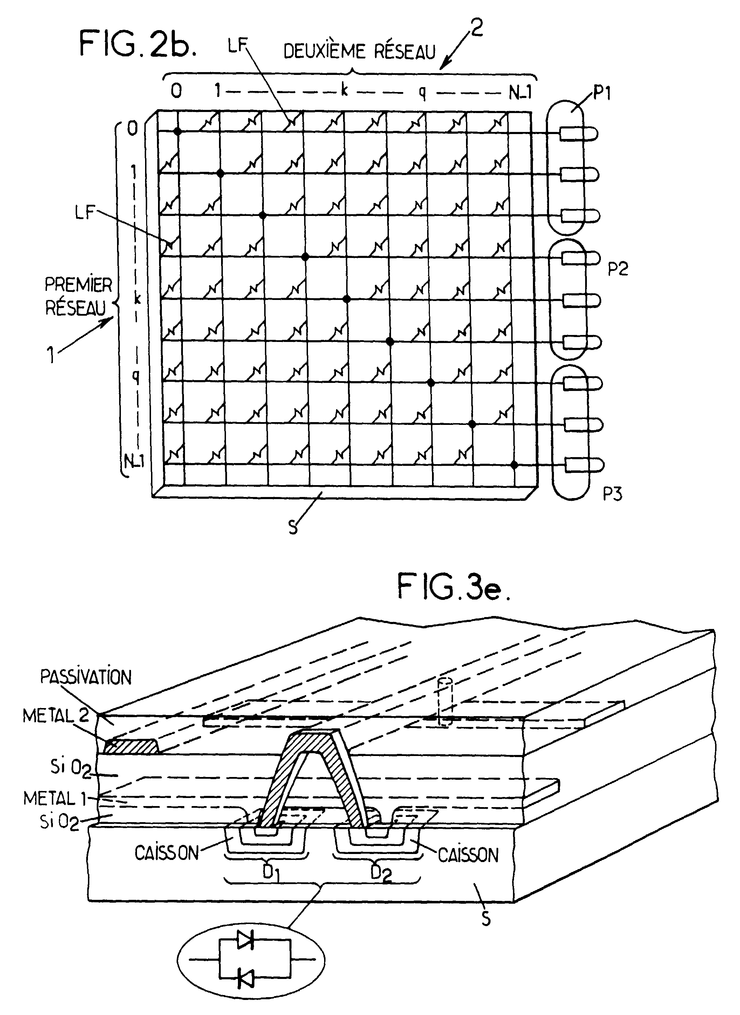

En outre, lorsque le support diélectrique est un substrat de type silicium par exemple, ainsi que représenté en figure 3e, les lignes horizontales peuvent utiliser un niveau de métallisation noté métal 1 et les lignes verticales un autre niveau de métallisation noté métal 2 par exemple. Les liaisons configurables, c'est-à-dire les liaisons fusibles LF, peuvent être alors réalisées soit par des sous-niveaux de métallisation d'épaisseur moindre ou par l'intermédiaire de trous traversants dimensionnés de telle façon que ceux-ci soient destructibles par des courants d'intensité de valeur Idest tel que Imax > Idest > In où In représente une valeur nominale donnée de courant, soit, ainsi que représenté en figure 3e, au moyen de deux diodes D1, D2 connectées en parallèle en tête-bêche.

Les lignes électriques du premier 1 et du deuxième réseau 2 sont alors formées sur une même face du support S, constitué par le substrat de silicium. Elles sont séparées par une couche de matériau électriquement isolant, tel que l'oxyde de silicium $SiO_2$ par exemple. L'ensemble est recouvert par une couche de passivation réalisée par exemple par une couche de nitrure de silicium de manière classique.

Le substrat silicium peut alors être encapsulé dans un boîtier plastique ou céramique.

Le nombre de lignes de chacun des ports doit être adapté à l'application considérée.

En raison du fait que les matrices de connexion configurables électriquement objet de la présente invention ne nécessitent aucune ligne d'alimentation, toutes les lignes peuvent être utilisées pour un raccordement aux broches des ports d'entrée/sortie. En conséquence, il est possible d'utiliser des boîtiers 16 (8x8), 24 (12x12), 32 (16x16) ou 48 (24x24) broches.

Dans de telles conditions, pour réaliser des câbles de transmission de données selon la recommandation V24 du CCITT, il est nécessaire d'utiliser une matrice d'interconnexion à 48 broches alors que pour la réalisation de câbles selon la recommandation V11 du CCITT, il suffit d'utiliser une matrice d'interconnexion à 32 broches. On indique que la largeur des bandes ou microbandes utilisées étant relativement grande, il est possible de mettre en oeuvre des technologies peu sophistiquées.

La matrice de connexion ayant été réalisée selon les schémas représentés précédemment, toutes les intersections entre les lignes électriques du premier 1 et du deuxième réseau 2 sont réunies.

La configuration de chaque matrice de connexion consiste alors, par programmation, à ouvrir toutes les liaisons inutiles pour ne garder que les chemins utiles à l'établissement d'un diagramme de connexions donné.

Ainsi qu'exprimé précédemment sous forme de relation logique, pour chaque interconnexion entre deux broches d'ordre différent du même port ou de ports différents, il existe deux interconnexions, l'une entre la verticale d'une broche donnée et l'horizontale de l'autre port, l'autre entre la verticale de l'autre port et l'horizontale du premier.

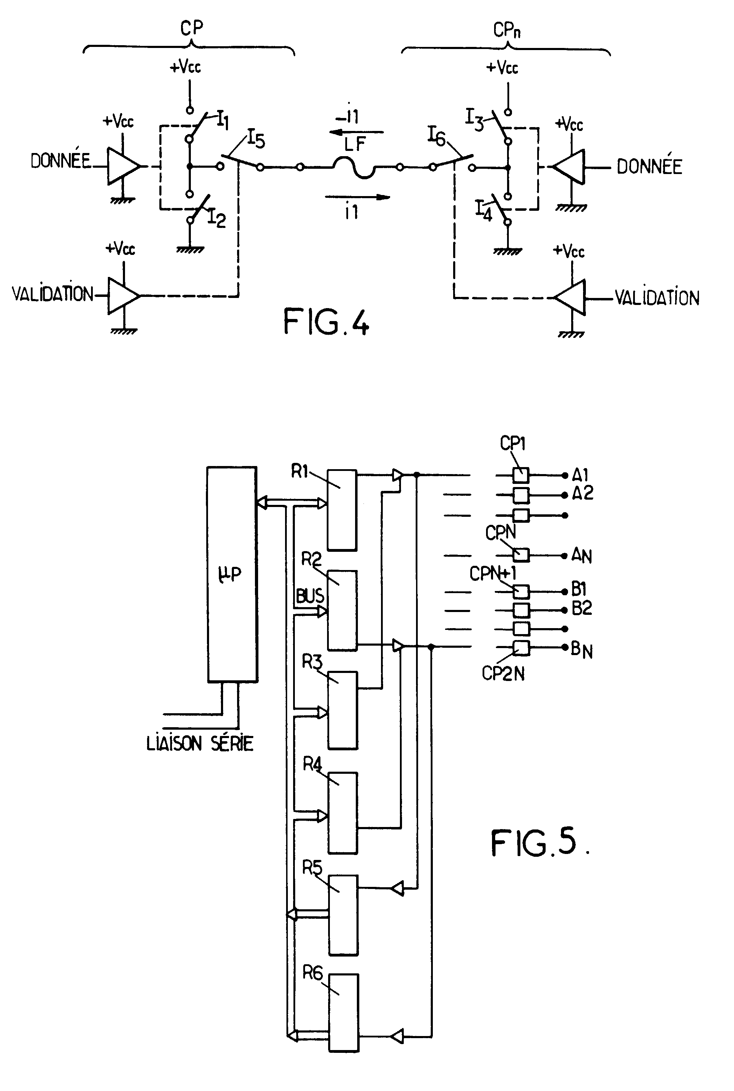

Pour des lignes électriques du premier réseau de rang pair 0 à 2j référencées B1 à Bn respectivement de rang impair 1 à 2j+1 référencées A1 à An, la configuration peut consister à relier chaque broche à un circuit de type circuit de puissance à trois états, ce circuit pouvant délivrer/absorber un courant d'intensité Iprog mais limité à une valeur inférieure à Imax, afin de ne pas détruire les lignes horizontales et les lignes verticales. Ce circuit peut par exemple, ainsi que représenté en figure 4, posséder une entrée de données permettant de placer la sortie, soit à une valeur de tension +V, soit à la tension de masse et une entrée de validation permettant de rendre la sortie active, c'est-à-dire à basse impédance ou à haute impédance aucun courant n'étant délivré. On comprend par exemple que la commande des interrupteurs $I_1$ à $I_6$ du circuit de puissance trois états permet d'alimenter la liaison configurable LF soit avec un courant $i_1$ ou $-i_1$ de sens opposé, $|i_1| = IF$, ce qui permet, lorsque la liaison fusible est formée par deux diodes montées en tête-bêche, de provoquer le claquage de l'une et l'autre de ces diodes successivement pour assurer la configuration de la matrice de connexion.

Les entrées de commande et de données précitées sont pilotées par un microcontrôleur par exemple à travers un jeu de registres ainsi qu'il sera décrit ci-après dans la description.

Sur chaque ligne horizontale, c'est-à-dire sur chaque ligne électrique du premier réseau, peut également être connectée une entrée d'un registre de lecture, lequel permet de contrôler l'état de la programmation pour des opérations de vérification.

La programmation en vue d'une configuration consiste à sélectionner un couple A1, A2, formant un couple équipotentiel par exemple, pour lequel la liaison électrique par l'intermédiaire des liaisons configurables doit être établie.

Les opérations effectuées peuvent alors consister :

- à mettre en valeur de haute impédance tous les circuits de puissance,
- à mettre à la valeur de la tension de masse tous les circuits de puissance,
- à passer à l'état actif tous les circuits de puissance,
- à appliquer sur les entrées de données du couple à isoler des impulsions de tension à la valeur +V,
- à lire l'état des ports pendant les états d'impulsion pour déterminer le moment où l'on peut passer à un ou plusieurs groupes de lignes équipotentielles suivantes.

Une étape de vérification consiste :

- à mettre en haute impédance toutes les sorties des circuits de puissance,
- à appliquer successivement un niveau de tension +V sur l'un des circuits de puissance rendu actif,
- à contrôler l'état de toutes les autres entrées et à les comparer avec la valeur désirée,
- à passer au circuit de puissance suivant.

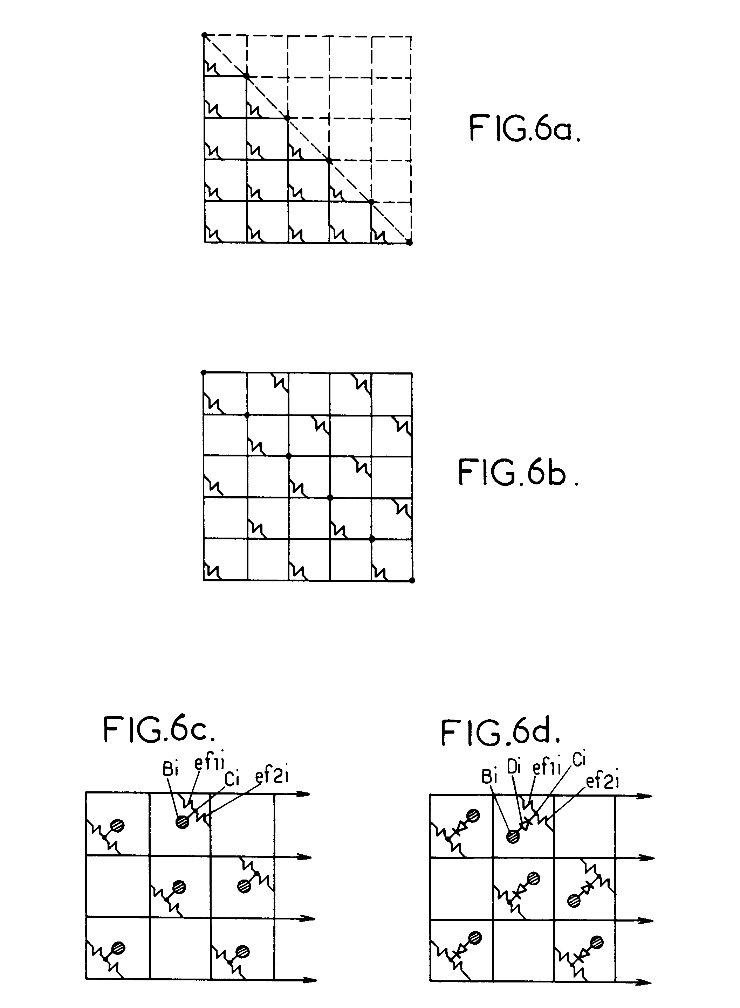

Sur la figure 5, on a représenté un schéma représentatif d'un programmateur spécifique permettant de réaliser la configuration à l'échelle industrielle de matrices de connexion conformes à l'objet de l'invention. Le programmateur comprend un microprocesseur μP relié par liaison par BUS à des registres $R_1$ à $R_4$ adressables en sortie et $R_5$ à $R_6$ adressables en entrée. Les registres $R_1$ à $R_4$ sont reliés à des circuits de puissance trois états $CP_1$ à $CP_{2N}$, tels que représentés en figure 4c, et sont commandés ainsi que mentionné précédemment, la sortie d'un circuit de puissance trois états $CP_k$ étant reliée à une broche et donc à une ligne du premier 1 ou du deuxième réseau 2. Les jeux de registres $R_1$ à $R_4$ permettent de commander les circuits de puissance trois états pour configurer une ou plusieurs matrices de connexion successives et les registres $R_5$ à $R_6$ permettent de contrôler l'état de la programmation effectuée. Le programmateur peut en outre être muni d'une interface de liaison série laquelle peut être connectée sur l'interface de liaison correspondante d'un micro-ordinateur, ou être réalisé sous forme d'une carte enfichable. La configuration et la vérification des matrices de connexion peuvent alors être conduites de la même façon que celles d'un programmateur d'EPROM standard.

Les divers modes de réalisation décrits précédemment dans la description de la matrice de connexion configurable électriquement, objet de la présente invention, permettent effectivement de mettre en liaison, à partir d'un port d'entrée/sortie, tous les autres ports d'entrée/sortie associés à chacune des liaisons de deux connexions configurables électriquement.

En effet, la matrice de connexion précédemment décrite associe en fait une connexion configurable électriquement à chaque de ligne de rang q avec une ligne de rang q+r, avec r≠0, r appartenant à [1-N, N-1].

Un mode de réalisation préférentiel d'une matrice de connexion configurable électriquement permettant de réaliser les mêmes combinaisons logiques d'interconnexion entre ports d'entrée/sortie que la matrice de connexion précédemment décrite mais permettant toutefois d'optimiser à un nombre minimum le nombre de connexions configurables électriquement nécessaires pour assurer tous types d'interconnexions possibles, sera maintenant donné en liaison avec les figures 6a, 6b et les figures suivantes.

Conformément aux figures précitées, on indique que pour un premier et un deuxième réseau comprenant chacun N lignes électriques distinctes, le nombre de connexions électriques configurables électriquement peut être optimisé et pris égal à $N_C = N(N-1)/2$.

Bien entendu, ce choix permet d'établir toute liaison entre deux lignes électriques adjacentes ou non du premier réseau, ainsi qu'il a été mentionné précédemment.

Ainsi qu'on l'a représenté en particulier en figure 6a, on indique que dans une première variante de réalisation, le premier et le deuxième réseau de lignes électriques distinctes sont limités chacun par l'ensemble des connexions électriques permanentes de rang k, le premier et le deuxième réseau s'étendant ainsi d'un seul et même côté de la limite, représentée sur la figure 6a par la diagonale en pointillés, formée par l'ensemble des connexions électriques permanentes.

Sur la figure 6a, on a représenté ainsi une structure triangulaire réalisée d'un seul et même côté de la diagonale des connexions électriques permanentes. Pour une structure équivalente du point de vue logique comportant en fait 6x6 lignes du premier respectivement du deuxième réseau, il suffit alors de prévoir, outre les connexions électriques permanentes, symbolisées par des points, une pluralité de $N_C = 15$ connexions configurables électriquement, c'est-à-dire 15 fusibles par exemple.

Ainsi qu'on l'a en outre représenté en figure 6b dans une deuxième variante de réalisation, le premier et le deuxième réseau de lignes électriques distinctes peuvent toutefois s'étendre de part et d'autre de la limite formée par l'ensemble des connexions électriques permanentes, c'est-à-dire la limite formée par la diagonale des connexions électriques permanentes sur la figure 6b. Toutefois, ainsi que représenté sur la figure précitée, une ligne électrique de rang q ≠ k appartenant au premier réseau est électriquement connectée par une connexion électrique configurable électriquement à l'état de conduction ou de non-conduction à la ligne de rang k appartenant au deuxième réseau, si la ligne électrique de rang q ≠ k du deuxième réseau n'est pas électriquement connectée par une connexion électrique configurable électriquement à l'état de conduction ou de non-conduction à la ligne de rang k appartenant au premier réseau, et réciproquement.

Dans la deuxième variante de réalisation telle que représentée en figure 6b, on indique que la structure ainsi réalisée est de type antisymétrique par rapport à la diagonale des connexions électriques permanentes, le caractère antisymétrique par rapport à cette diagonale, représentée en pointillés sur la figure 6b, apparaissant du fait qu'en tout point d'intersection d'une ligne électrique de rang q du premier réseau et d'une ligne électrique de rang q+r du deuxième réseau, point d'intersection pour lequel il existe ou non une connexion configurable électriquement, correspond un point symétrique d'intersection des lignes de rang q+r du premier réseau et de rang q du deuxième réseau, point symétrique par rapport à la diagonale des connexions permanentes, pour lequel, au contraire, il n'existe pas, ou il existe, une connexion configurable électriquement, et réciproquement.

Ce mode de réalisation tel que représenté en figure 6b est particulièrement avantageux dans la mesure où il permet d'optimiser l'espacement d'implantation des connexions électriques configurables à l'état de conduction ou de non conduction, c'est-à-dire en fait de rendre maximum la distance séparant deux fusibles consécutifs, cette distance, pour un pas p du réseau, étant portée à la valeur de la diagonale du carré de dimensions correspondantes.

On comprend ainsi que le mode de réalisation tel que représenté en figure 6b permet de minimiser localement l'échauffement de la matrice de connexion lors de la configuration de celle-ci par programmation.

Un tel mode de réalisation pourra donc être réservé pour la fabrication de matrices de connexions configurables sous forme de circuits intégrés afin d'éviter des échauffements trop importants.

D'une manière générale, dans l'ensemble des modes de réalisation de la matrice de connexion configurable, objet de la présente invention tels que décrits précédemment dans la description, les connexions configurables électriquement à l'état de conduction ou de non-conduction peuvent être formées, soit par des fusibles, soit par des encres conductrices, ou encore par des diodes montées en tête-bêche en logique positive ou négative.

Le terme de logique positive ou négative correspond au fait qu'en logique positive par exemple, tous les points d'intersection des lignes du premier respectivement du deuxième réseau autres que celles munies d'une connexion électrique permanente, sont munies par exemple d'une connexion électrique fusible avant toute configuration. A contrario, le terme de logique négative correspond au cas où les intersections précitées sont exemptes, avant toute configuration, d'une liaison électrique fusible, la configuration pouvant alors consister à introduire une connexion électrique en des points d'intersection déterminés.

A titre d'exemple non limitatif, on indique que lorsque en logique positive des éléments fusibles tels que des filigranes de cuivre sont utilisés, il est nécessaire d'apporter des courants de fusion relativement importants dans la mesure où la température de fusion du cuivre est de 1083°C.

Dans le cadre d'une logique négative, au contraire, les matrices de connexion configurables, objets de la présente invention, sont conçues avec toutes les liaisons programmables ouvertes lors de la gravure du circuit imprimé.

Une opération supplémentaire consiste alors à introduire dans le processus de fabrication une étape de dépôt d'un fusible d'une nature différente de celle des lignes électriques.

Pour la mise en oeuvre de fusibles à l'étain-plomb lors de la production de circuits imprimés, un vernis épargne peut être déposé sur les lignes horizontales et les lignes verticales constitutives des lignes du premier et du deuxième réseau. Seules sont alors épargnées des plages composées unitairement d'un conducteur interrompu.

La matrice de connexion ainsi réalisée peut alors être passée dans un bain d'étain-plomb à la vague, selon les techniques normales de soudage avec une température et une vitesse contrôlées.

En conséquence du mode opératoire précité, une liaison de soudure est réalisée en fonction de l'orientation des plages épargnées, cette liaison étant réalisée entre les deux parties de la piste interrompue formant ainsi un fusible à l'étain-plomb dont la température de fusion n'excède pas 300°C.

La température de la vague ainsi que la vitesse de défilement du circuit permettent alors de contrôler l'épaisseur de matière déposée.

D'autres types de matières fusibles peuvent être utilisés.

En particulier, en partant du principe d'une logique négative avec épargne des plages conductrices de chaque fusible, on peut alors introduire dans le processus de fabrication un dépôt par sérigraphie d'une encre conductrice formant fusible entre chaque extrémité unitaire d'une plage fusible.

Cette trace d'encre conductrice ainsi formée, dont la nature peut être spécifiquement adaptée, encre à l'or, à l'argent, au plomb ou à un alliage déterminé, forme alors un élément fusible dont la résistance à la fusion peut être contrôlée par l'épaisseur du dépôt réalisé.

La programmation d'une telle matrice de connexion peut alors être réalisée ainsi que décrit précédemment dans la description par exemple.

En ce qui concerne les différentes connexions utiles, celles-ci, étant susceptibles de permettre d'atteindre l'une ou l'autre des connexions électriquement configurables, peuvent être réalisées à la demande selon une technique consistant à déposer sélectivement des empreintes conductrices à base d'encre conductrice sur les liaisons déterminées par les besoins du produit final.

Le dépôt d'encre conductrice peut alors être effectué grâce à un système de projection de type jet d'encre dans lequel l'encre est diffusée au travers d'une buse de petite dimension. Le guidage du flux d'encre peut être assuré, soit par déplacement XY, soit par déviation dans un champ électrique, selon des techniques connues.

Une troisième variante de réalisation d'une matrice de connexion, objet de la présente invention, sera maintenant décrite lorsque cette matrice de connexion configurable est réalisée sous forme de circuit intégré. Ces modes de réalisation sont donnés en liaison avec les figures 6c et 6d.

Ainsi que représenté sur les figures précitées, on indique que, dans un tel cas, les connexions électriques configurables électriquement à l'état de conduction ou de non-conduction sont formées par un premier et un deuxième élément fusible, notés $ef_{1i}$, $ef_{2i}$ sur les figures précitées, ces éléments fusibles étant interconnectés en série entre une ligne électrique du premier et du deuxième réseau.

En outre, une borne d'application d'un signal de configuration par programmation est prévue, cette borne étant électriquement reliée au point milieu d'interconnexion du premier et du deuxième élément fusible $ef_{1i}$, $ef_{2i}$.

On comprend bien sûr que la liaison entre la borne d'application du signal de configuration et le point milieu précité peut être réalisée grâce aux techniques de métallisation précédemment décrites. La borne d'application du signal de configuration $B_i$ peut elle-même être réalisée par une métallisation formant un plot spécifique.

Ainsi qu'on l'a en outre représenté en figure 6d, la borne $B_i$ peut avantageusement être reliée au point milieu par l'intermédiaire d'une diode.

Lors de la configuration de la matrice de connexion configurable telle que représentée en figure 6c ou 6d, le mode opératoire peut consister alors à relier l'ensemble des ports d'entrée/sortie référencés $A_1$, $A_2$, $A_3$, $A_4$ par exemple à un potentiel commun, relié par exemple à une des bornes d'un générateur de tension, et à appliquer le potentiel de l'autre borne de ce générateur sur le point milieu $C_i$ par l'intermédiaire de la borne $B_i$ par exemple.

Dans un tel cas, le courant de fusion des éléments fusibles provoque la rupture de l'un, $ef_{1i}$, puis de l'autre, $ef_{2i}$, par exemple, et uniquement de ces éléments-là.

La solution précitée peut alors être mise en oeuvre en particulier pour la programmation de matrices de connexions configurables réalisées sous forme de circuits intégrés.

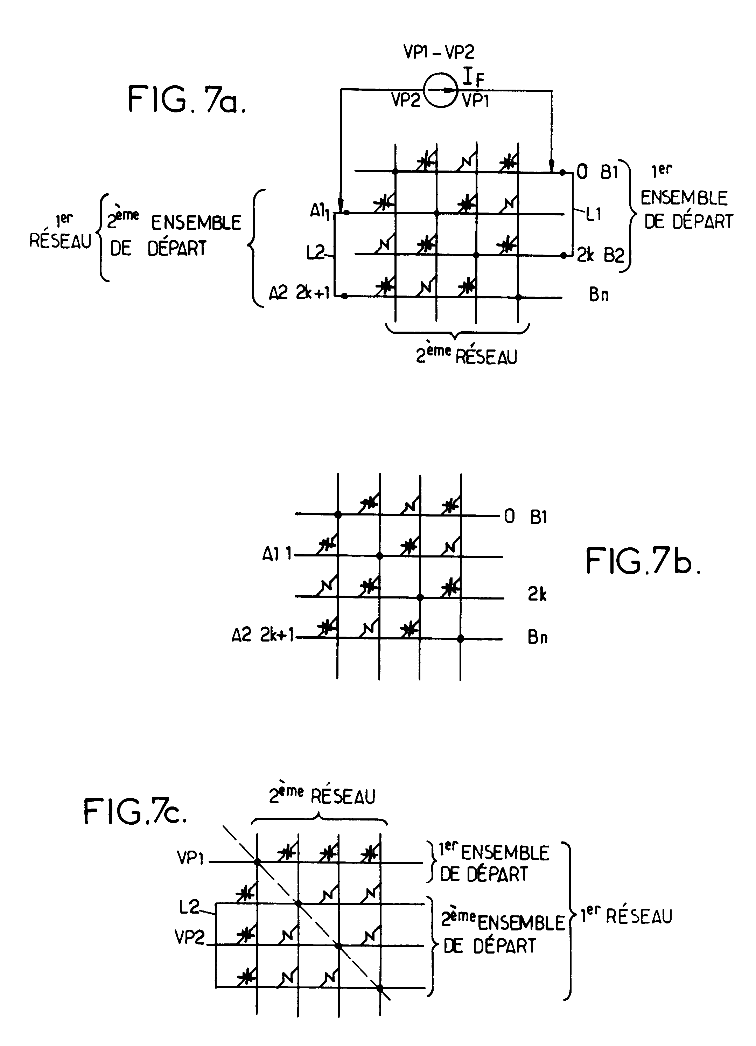

Une description plus détaillée d'un procédé de configuration programmée d'une matrice de connexion configurable, objet de la présente invention, telle que décrite précédemment dans la description, sera maintenant donnée en liaison avec les figures 7a, 7b et 7c.

D'une manière générale, on indique que le procédé de configuration programmée précité peut être bien entendu mis en oeuvre, soit pour une matrice de connexion configurable électriquement dans laquelle le nombre de connexions configurables électriquement n'est pas optimisé, soit, au contraire, lorsque ce nombre est optimisé.

Dans tous les cas, on indique que l'on considère que la matrice de connexion programmable soumise au processus de configuration programmée est constituée par une matrice comportant NxN lignes électriques constituant le premier et le deuxième réseau.

Ainsi qu'on l'a représenté de manière schématique en figure 7a, le procédé de configuration programmée consiste, dans une étape a, à appliquer à un premier ensemble de départ comportant Q lignes électriques du premier réseau, un premier potentiel électrique de programmation de valeur déterminée. Sur la figure 7a, on comprend que les Q lignes électriques du premier réseau sont égales à deux et portent la référence 0,2k lignes paires pour les bornes $B_1$, $B_2$. Le potentiel appliqué est réputé égal à $VP_1$, les lignes 0 et 2k étant interconnectées grâce à une liaison électrique $L_1$ appliquée au niveau des bornes $B_1$ et $B_2$.

Le procédé de configuration programmée consiste en outre, en une étape b, à appliquer à un deuxième ensemble de départ comportant P lignes électriques du même premier réseau, un deuxième potentiel électrique de programmation de valeur déterminée. Sur la figure 7a, de manière non limitative et à seul titre d'exemple, le deuxième ensemble de départ comporte P=2 lignes électriques du premier réseau portant les références 1, 2k+1 lignes impaires, ces lignes étant reliées aux bornes $A_1$ et $A_2$. Le deuxième potentiel électrique de programmation a la valeur $VP_2$ et est appliqué aux P lignes, c'est-à-dire aux lignes 1 et 2k+1 par l'intermédiaire d'une liaison électrique $L_2$ appliquée sur les bornes $A_1$ et $A_2$.

L'application simultanée du premier et du deuxième potentiel électrique de programmation sur le premier, respectivement le deuxième ensemble de départ, permet de maintenir à l'état de conduction initial toute connexion électrique configurable d'adresse k dans le deuxième réseau assurant la connexion électrique entre deux lignes électriques du premier ensemble de départ, et de placer à l'état de non-conduction toute connexion électrique configurable d'adresse k dans le deuxième réseau assurant la connexion électrique entre une ligne électrique du premier et du deuxième sous-ensemble de départ.

On comprend bien entendu que, pour assurer les opérations de maintien en l'état de conduction initial ou de mise à l'état de non-conduction précités, il suffit que la différence de potentiel $VP_2-VP_1$ soit suffisante pour engendrer le courant de fusion IF précédemment mentionné dans la description.

Suite à la réalisation des étapes a et b précitées, on obtient, ainsi que représenté en figure 7b, la configuration correspondante dans laquelle les connexions configurables électriquement qui ont été placées à l'état de non-conduction ont purement et simplement été supprimées, alors que celles qui ont été maintenues à l'état initial de conduction sont seules représentées.

Suite aux étapes a,b précitées, le procédé de configuration programmée d'une matrice de connexion configurable objet de l'invention, consiste ensuite à répéter les opérations a et b sur des sous-ensembles successifs des premier et deuxième ensembles de départ pour obtenir une configuration finale.

Du point de vue du mode opératoire du procédé de configuration programmée précédemment décrit en liaison avec la figure 7a et la figure 7b, on indique que le fait de relier les ports d'entrée/sortie du premier ensemble de départ, respectivement du deuxième ensemble de départ, et d'ailleurs successivement pour tout sous-ensemble correspondant de ces derniers, a pour effet de faire circuler le courant de fusion IF issu du générateur simultanément dans tous les fusibles ou connexions configurables électriquement situés entre ces deux ensembles, le premier respectivement le deuxième ensemble de départ, et dans ces connexions configurables électriquement seulement.

Le courant de fusion IF étant réputé suffisant, les connexions configurables électriquement se rompent les unes après les autres et permettent d'isoler le sous-ensemble équipotentiel considéré.

La répétition du processus de programmation selon les étapes a et b conformément à l'étape c précédemment décrite, pour le premier ou le deuxième ensemble de départ selon deux sous-ensembles correspondants, permet d'obtenir la configuration finale selon une pluralité d'ensembles et de sous-ensembles correspondante.

On indique que la détection de la fin de la programmation peut alors être effectuée de façon particulièrement avantageuse dans la mesure où cette détection peut être effectuée automatiquement en mesurant le courant circulant entre les deux sous-ensembles. Lorsque le courant devient nul, les ensembles sont isolés l'un de l'autre.

Une description plus détaillée d'une variante optimisée du procédé de configuration programmée précédemment décrite dans la description avec les figures 7a et 7b sera maintenant donnée, notamment avec la figure 7c.

Cette variante optimisée peut bien entendu être mise en oeuvre, ...soit pour un nombre de connexions électriques configurables, non optimisées ou optimisées. Dans ce dernier cas, le nombre de ces connexions électriques configurables est égal à $N_C = N(N-1)/2$.

Dans le cas précité, le nombre de connexions électriques configurables contenues dans le premier ensemble de départ est égal à $N_{CQ} = Q(Q-1)/2$ où Q désigne bien entendu le nombre de lignes du premier réseau constituant le premier ensemble de départ.

De la même façon, le nombre de connexions électriques configurables contenues dans le deuxième ensemble de départ est égal à $N_{CP} = P(P-1)/2$ où P désigne le nombre de connexions électriquement configurables contenues dans le deuxième ensemble de départ.

Le nombre de connexions électriquement configurables reliant le premier ensemble de départ au deuxième ensemble de départ est donné par la relation :

$$N_{CQP} = Q(N-Q), \text{ car } N = Q+P.$$

On constate donc que ce nombre de connexions électriquement configurables assurant la liaison entre les lignes électriques du premier et du deuxième ensemble de départ est une fonction croissante sur l'intervalle $Q \in [1,N/2]$ puis décroissante sur l'intervalle $Q \in [N/2,N]$.

Dans ces conditions, le procédé de configuration programmée dans sa variante de réalisation consiste, en une étape d, à choisir, comme premier ensemble de départ, l'ensemble de lignes électriques du premier réseau comportant le nombre minimum de lignes électriques pour une application considérée, le minimum minimorum étant alors égal à une ligne électrique constituant le premier ensemble de départ.

Dans ces conditions, le procédé précité consiste alors à choisir comme deuxième ensemble de départ, en une étape e, l'ensemble complémentaire du premier ensemble de départ sur l'ensemble formé par la totalité des lignes électriques du premier réseau.

Ce mode opératoire permet d'optimiser localement à un nombre minimum le nombre de connexions électriquement configurables soumises à l'opération de configuration.

Grâce à la répétition d'un tel mode opératoire, on comprend bien entendu qu'il est possible de rendre minimum le nombre de connexions électriquement configurables soumises à l'opération de configuration.

Ainsi qu'on l'a représenté en figure 7c, dans le cas où le premier ensemble de départ de l'ensemble des lignes électriques du premier réseau comporte une seule ligne, cette ligne est portée au potentiel $VP_1$, alors que toutes les lignes du deuxième ensemble de départ du premier réseau sont portées au potentiel $VP_2$ grâce à la liaison électrique $L_2$ représentée sur la figure 7c.

Pour une matrice de connexion comportant un nombre de connexions configurables électriquement optimisées, c'est-à-dire pour une matrice formée par une matrice triangulaire, constituée par exemple par la partie située à gauche de la diagonale des connexions permanentes, le nombre de connexions électriquement configurables à rompre est égal à N-1, c'est-à-dire 3 dans le cas non limitatif de la figure 7c.

Le processus peut alors être repris sur le deuxième ensemble de départ pour réaliser une configuration déterminée, et ainsi de suite.

On comprend ainsi que la valeur de N prend chaque fois la valeur du nombre de ports contenus dans le reste considéré, N initialement égal à 4 dans le cas de la figure 7c devenant, suite à l'application des étapes d et e précédemment décrites, égal à 3 pour les lignes électriques constitutives du deuxième ensemble de départ.

On comprend bien entendu que, bien que décrit relativement à un nombre de lignes et donc de ports d'entrée/sortie relativement faible, le procédé objet de la présente invention est particulièrement avantageux puisqu'il permet une optimisation des opérations à effectuer pour la programmation grâce à une matrice configurable, objet de la présente invention, de systèmes d'entrée/sortie comportant jusqu'à 50 ports ou plus.

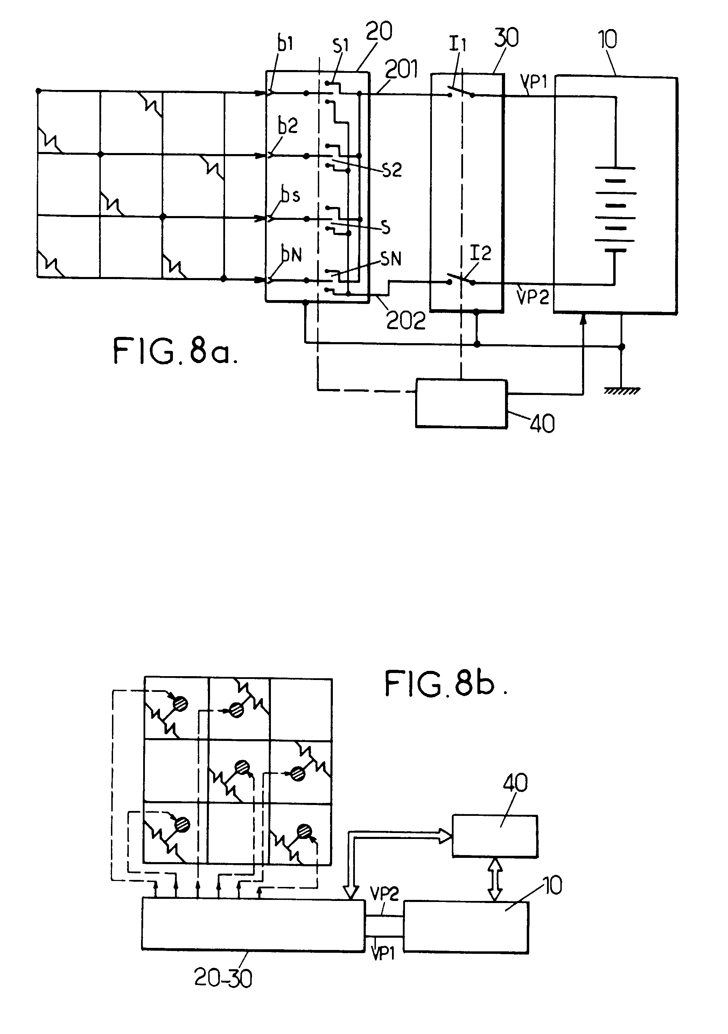

Une description plus détaillée d'un dispositif permettant d'assurer la configuration programmée d'une matrice de connexion conformément par exemple au procédé de programmation précédemment décrit, sera maintenant donnée en liaison avec les figures 8a et 8b.

D'une manière générale, en liaison avec la figure 8a, on indique que le dispositif selon l'invention comporte au moins un circuit 10 générateur d'au moins deux tensions de programmation distinctes, ce circuit 10 pouvant consister par exemple en une alimentation de puissance stabilisée susceptible de délivrer les deux potentiels de programmation précités $VP_1$ et $VP_2$. Ce générateur est symbolisé par une batterie par exemple d'accumulateur, et de préférence réalisé par une alimentation stabilisée.

En outre, le dispositif tel que représenté en figure 8a comprend un circuit d'interconnexion sélective, noté 20, des lignes électriques du premier réseau de la matrice de connexion selon un premier et un deuxième ensemble de départ. Le circuit 20 peut comprendre à cet effet une série de commutateurs, notés $S_1$, $S_2$ à $S_N$ à double-position dont les bornes de commutation sont reliées à une première, respectivement une deuxième entrée, notées 201, 202, et dont la borne commutée est reliée à une borne de sortie destinée à recevoir une borne correspondante de la matrice de connexion configurable objet de la présente invention. Les bornes sont notées $b_1$ à $b_N$.

En outre, un circuit 30 d'application des potentiels de programmation $VP_1$ et $VP_2$ est prévu, ce circuit 30 pouvant consister par exemple en deux interrupteurs commandés, $I_1$ et $I_2$ interconnectés, d'une part, aux bornes de sortie des potentiels $VP_1$ et $VP_2$ délivrés par le circuit générateur 10, et, d'autre part, aux bornes d'entrée 201, 202 du circuit d'interconnexion sélective 20.

Bien entendu, les interrupteurs $I_1$, $I_2$ commandés et les commutateurs $S_1$, $S_2$ sont également commandés par l'intermédiaire d'un circuit de pilotage 40, lequel peut être un circuit à microprocesseur permettant de commander, non seulement la mise en marche de l'alimentation stabilisée constituant le circuit générateur 10, mais également les interrupteurs commandés $I_1$ et $I_2$ et les commutateurs $S_1$ à $S_N$.

Bien entendu, le circuit de pilotage 40 peut être muni d'un programme permettant de réaliser la mise en oeuvre du procédé conformément au procédé précédemment décrit dans la description, c'est-à-dire en subdivisant par configuration des commutateurs $S_1$ à $S_N$ la matrice de connexion considérée en premier et deuxième ensembles de départ, puis en appliquant par l'intermédiaire des interrupteurs commandés $I_1$ et $I_2$ les potentiels de configuration $VP_1$ et $VP_2$, et, en modifiant ensuite la configuration des commutateurs $S_1$ à $S_N$, réitérer le processus de programmation pour les sous-ensembles suivants.

Lorsque la matrice de connexion configurable, objet de la présente invention, est réalisée sous forme de circuit intégré, il peut alors être avantageux, lorsque les connexions électriquement configurables à l'état de conduction ou de non-conduction sont formées par deux éléments fusibles en cascade réunis à une borne en leur point milieu, de réaliser les circuits d'interconnexion sélective 20 et d'application des tensions de programmation 30 en un seul élément, noté 20-30 sur la figure 8b, de façon à simplifier la mise en oeuvre. Dans un tel cas, on indique que ces deux circuits peuvent avantageusement être formés par un registre à décalage à N(N-1)/2 sorties programmables. Ce registre à décalage peut alors être implanté directement sur la matrice de connexion, latéralement à celle-ci.

Dans ce cas, chaque sortie peut alors être interconnectée à la borne $B_i$ d'application du potentiel de programmation précédemment représenté en figure 6c.

Il va de soit que la liaison entre le circuit 20-30, c'est-à-dire les sorties du registre à décalage considéré, et les bornes Bi peut être réalisée au moyen de lignes conductrices spécifiques. L'ensemble des lignes du premier réseau est relié à l'un des potentiels $VP_1$ ou $VP_2$ pendant la programmation.

Dans un tel cas, chaque sortie du registre à décalage est alors programmée en fonction de l'adresse de chaque plot Bi pour délivrer l'une ou l'autre des tensions de programmation et réaliser ainsi une configuration par programmation, ainsi que décrit précédemment dans la description par subdivision en un premier et en un deuxième ensemble de départ et réitération successive sur les sous-ensembles correspondants, ou même, dans le cas plus spécifide circuits intégrés, par une programmation par adresse successive ainsi que décrit en liaison avec la figure 6c et la figure 6d.

On comprendra bien sûr que la solution consistant à utiliser un registre à décalage est particulièrement avantageuse dans la mesure où celui-ci n'est alimenté que pendant la phase de programmation.

## Revendications

1. Matrice de connexion configurable électriquement entre lignes d'au moins un port d'entrée/sortie à N broches, caractérisée en ce que celle-ci comprend :

   - un support diélectrique, et sur ce support,
   - une pluralité de N lignes électriques distinctes formant un premier réseau, chaque ligne électrique de ce premier réseau étant connectée à une broche du port d'entrée /sortie, et
   - une pluralité de N lignes électriques distinctes formant un deuxième réseau, distinct du premier réseau, chaque ligne électrique de rang k, $k \in [0, N-1]$ du premier réseau étant électriquement connectée par une connexion électrique permanente à la ligne électrique de même rang k appartenant au deuxième réseau et chaque ligne électrique de rang $q \neq k$ appartenant au premier réseau étant électriquement connectée par une connexion électrique configurable à l'état de conduction ou de non-conduction à la ligne électrique de rang k appartenant au deuxième réseau, ce qui permet par commande de maintien de l'état de conduction ou de passage à l'état de non-conduction d'une pluralité desdites connexions électriques configurables d'assurer la liaison électrique entre deux lignes électriques adjacentes ou non du premier réseau.

2. Matrice de connexion selon la revendication 1, caractérisée en ce que les lignes électriques du premier respectivement du deuxième réseau sont sensiblement parallèles entre elles, les lignes électriques du premier réseau étant orientées dans une première direction et les lignes électriques du deuxième réseau étant orientées dans une deuxième direction, transversale à la première, chaque ligne du premier et du deuxième réseau étant repérée par son rang k, k+r pair ou impair, avec k ∈ [0, N-1] et r ≠ 0 ∈ [1-N, N-1], l'interconnexion électrique entre deux lignes de rang k et k+r adjacentes ou non du premier réseau étant obtenue pour la relation logique :

Ak . Ak+r

si

   Tk,k ET Tk+r,k OU
   Tk,k+r ET Tk+r, k+r
relation logique dans laquelle :
Ak . Ak+r
     désigne la valeur logique vraie d'interconnexion des lignes A de rang k respectivement k+r du premier réseau, et, le premier respectivement le deuxième indice désignant le rang des lignes du premier respectivement du deuxième réseau :
Tk,k et Tk+r,k+r
     désigne la valeur logique vraie de la connexion électrique permanente d'adresse k, k respectivement k+r, k+r entre ligne électrique de même rang du premier et du deuxième réseau,
Tk, k+r et Tk+r,k
     désigne la valeur logique vraie de l'état de conduction des connexions électriques configurables d'adresses correspondante k,k+r et k+r,k entre lignes électriques du premier respectivement du deuxième réseau, toutes les autres connexions électriques configurables connectées aux lignes électriques interconnectées de rang k,k+r du premier réseau étant à la valeur logique complémentée de l'état de non-conduction, pour une interconnexion desdites seules lignes de rang k,k+r du premier réseau.

3.   Matrice de connexion selon l'une des revendications précédentes, caractérisée en ce que lesdites lignes électriques sont formées par des lignes à ruban ou micro-bandes sensiblement rectilignes, les lignes électriques de rang pair k = 2j du premier réseau étant reliées à une de leurs extrémités à un premier port d'entrée/sortie et les lignes électriques de rang impair k = 2j+1 du premier réseau étant reliées à l'autre de leurs extrémités à un deuxième port d'entrée/sortie.

4.   Matrice de connexion selon l'une des revendications précédentes, caractérisée en ce que lesdites lignes électriques sont formées par des lignes à ruban ou micro-bandes sensiblement rectilignes, les lignes électriques étant subdivisées en groupes de lignes interconnectées ou non, les lignes de chaque groupe étant connectées à un port d'entrée/sortie distinct.

5.   Matrice de connexion selon la revendication 3 ou 4, caractérisée en ce que lesdites lignes à ruban ou microbandes sont formées sur un support diélectrique du type plaquette de circuit imprimé, substrat céramique ou silicium.

6.   Matrice de connexion selon l'une des revendications précédentes, caractérisée en ce que lesdites lignes électriques du premier réseau sont formées sur une première face du support et les lignes électriques du deuxième réseau sont formées sur une deuxième face du support, les connexions électriques permanentes étant formées par des trous traversants munis d'une métallisation et les connexions électriques configurables étant formées par des liaisons électriques fusibles pour lesquelles la commande à l'état non conducteur est obtenue sur alimentation par un courant d'intensité supérieure à une valeur de seuil déterminée.

7.   Matrice de connexion selon l'une des revendications précédentes, caractérisée en ce que les lignes électriques du premier et du deuxième réseau sont formées sur une même face du support, les lignes électriques du premier respectivement du deuxième réseau étant séparées par une couche de matériau électriquement isolant, les connexions électriques permanentes étant formées par des trous traversants munis d'une métallisation et les connexions électriques configurables étant formées par des liaisons électriques fusibles pour lesquelles la commande à l'état non conducteur est obtenue sur alimentation par un courant d'intensité supérieure à une valeur de seuil déterminée.

8.   Matrice de connexion selon l'une des revendications 6 ou 7, caractérisée en ce que lesdites liaisons électriques sont formées par un fusible électrique ou deux diodes montées en tête-bêche.

9.   Matrice de connexion selon l'une des revendications précédentes, caractérisée en ce que, pour un premier et un deuxième réseau comprenant chacun N lignes électriques distinctes, le nombre de connexions électriques configurables est optimisé et égal à $N_C = N(N-1)/2$, ce qui permet d'établir toute liaison entre deux lignes électriques adjacentes ou non du premier réseau.

10.  Matrice de connexion selon la revendication 9, caractérisée en ce que le premier et le deuxième réseau de lignes électriques distinctes sont limités chacun par l'ensemble des connexions électriques permanentes de rang k, lesdits premier et deuxième réseaux s'étendant d'un seul et même côté de la ligne limite formée par l'ensemble des connexions électriques permanentes.

**11.** Matrice de connexion selon la revendication 9, caractérisée en ce que le premier et le deuxième réseau de lignes électriques distinctes s'étendent de part et d'autre de la limite formée par l'ensemble des connexions électriques permanentes, une ligne électrique de rang q≠k appartenant au premier réseau étant électriquement connectée par une connexion électrique configurable à l'état de conduction ou de non-conduction à la ligne de rang k appartenant au deuxième réseau si la ligne électrique de rang q≠k du deuxième réseau n'est pas électriquement connectée par une connexion électrique configurable à l'état de conduction ou de non-conduction à la ligne de rang k appartenant au premier réseau, et réciproquement, ce qui permet d'optimiser l'espacement de l'implantation des connexions électriques configurables à l'état de conduction ou de non-conduction en vue de minimiser localement l'échauffement de la matrice de connexion lors de la configuration de la matrice de connexion par programmation.

**12.** Matrice de connexion selon l'une des revendications 5 à 11, caractérisée en ce que lesdites connexions électriques configurables à l'état de conduction ou de non-conduction appartiennent au groupe formé par les fusibles, encres conductrices, diodes montées en tête-bêche, en logique positive ou négative.

**13.** Matrice de connexion selon la revendication 12, caractérisée en ce que ladite matrice de connexion étant réalisée sous forme d'un circuit intégré, lesdites connexions électriques configurables à l'état de conduction ou de non-conduction sont formées par :

- un premier et un deuxième élément fusible inter-connectés en série entre une ligne électrique du premier et du deuxième réseau,
- une borne d'application d'un signal de configuration par programmation, ladite borne étant électriquement reliée au point milieu d'interconnexion du premier et du deuxième élément fusible.

**14.** Matrice de connexion selon la revendication 13, caractérisée en ce que ladite borne est reliée au point milieu par l'intermédiaire d'une diode.

**15.** Procédé de configuration programmée d'une matrice de connexion configurable selon l'une des revendications 1 à 14, caractérisé en ce que, pour une matrice comportant NxN lignes électriques constituant le premier et le deuxième réseau, celui-ci consiste à :

    a)- appliquer à un premier ensemble de départ comportant Q lignes électriques du premier réseau, un premier potentiel électrique de programmation de valeur déterminée ;
    b)- appliquer à un deuxième ensemble de départ comportant P lignes électriques du premier réseau, un deuxième potentiel électrique de programmation de valeur déterminée, ce qui permet de maintenir à l'état de conduction initial toute connexion électrique configurable d'adresse k dans le deuxième réseau assurant la connexion électrique entre deux lignes électriques du premier ensemble de départ et de placer à l'état de non-conduction toute connexion électrique configurable d'adresse k dans le deuxième réseau assurant la connexion électrique entre une ligne électrique du premier et du deuxième ensemble de départ ;
    c)- à répéter les opérations a) et b) sur des sous-ensembles successifs des premier et deuxième ensembles de départ, pour obtenir une configuration finale.

**16.** Procédé selon la revendication 15, caractérisé en ce que, pour un nombre de connexions électriques configurables optimisé $N_C = N(N-1)/2$, le nombre de connexions électriques configurables contenues dans le premier ensemble de départ étant égal à $N_{CQ} = Q(Q-1)/2$, le nombre de connexions électriques configurables contenues dans le deuxième ensemble de départ étant égal à $N_{CP} = P(P-1)/2$ et le nombre de connexions électriquement configurables assurant la liaison entre les lignes électriques du premier et du deuxième ensemble de départ étant égal à $N_{CQP} = Q(N-Q)$, ledit procédé consiste à :

    d)- choisir comme premier ensemble de départ l'ensemble de lignes électriques du premier réseau comportant le nombre minimum de lignes électriques ;
    e)- choisir comme deuxième ensemble de départ l'ensemble complémentaire du premier ensemble de départ, sur l'ensemble formé par la totalité des lignes électriques du premier réseau, ce qui permet d'optimiser le nombre de connexions électriquement configurables soumises à l'opération de configuration.

**17.** Dispositif de configuration programmée d'une matrice de connexion selon l'une des revendications 1 à 14 précédentes, caractérisé en ce qu'il comporte au moins :

- des moyens générateurs d'au moins deux potentiels de programmation distinctes ;
- des moyens d'interconnexion sélective des lignes électriques du premier réseau de ladite matrice de connexion selon un premier et un deuxième ensemble de départ, le premier respectivement le deuxième ensemble de départ étant constitué chacun par des lignes électriques électriquement connectées entre elles, les lignes électriques du premier ensemble de départ étant isolées électriquement des lignes électriques du deuxième ensemble de départ ;

- des moyens d'application desdits potentiels de programmation distincts aux lignes électriques du premier respectivement du deuxième ensemble de départ.

18. Dispositif selon la revendication 17, caractérisé en ce que, pour une matrice de connexion dans laquelle les connexions électriquement configurables à l'état de conduction ou de non-conduction sont formées par deux éléments fusibles en cascade réunis à une borne en leur point milieu, lesdits moyens d'interconnexion sélective et d'application des potentiels de programmation sont constitués par un registre à décalage à N(N-1)/2 sorties programmables, chaque sortie étant interconnectée à ladite borne d'application d'un potentiel de programmation, chaque sortie du registre à décalage étant programmée pour délivrer l'un ou l'autre des potentiels de programmation.

## Patentansprüche

1. Elektrisch konfigurierbare Matrix zur Verbindungsherstellung zwischen Leitungen mindestens einer Eingangs-/Ausgangsanschlußanordnung mit N Anschlußstiften, dadurch gekennzeichnet, daß sie umfaßt:

- einen dielektrischen Träger und auf diesem Träger
- eine ein erstes Netz bildende Mehrzahl von N gesonderten elektrischen Leitungen, wobei jede elektrische Leitung dieses ersten Netzes mit einem Anschlußstift der Eingangs-/Ausgangsanschlußanordnung verbunden ist, und
- eine ein von dem ersten Netz gesondertes zweites Netz bildende Mehrzahl von N gesonderten elektrischen Leitungen, wobei jede elektrische Leitung des ersten Netzes vom Rang k, $k \in [0, N-1]$, durch eine permanente elektrische Verbindung mit der dem zweiten Netz zugehörigen elektrischen Leitung gleichen Rangs k elektrisch verbunden ist und jede dem ersten Netz zugehörige elektrische Leitung vom Rang $q \neq k$ durch eine in den leitenden Zustand oder den nicht leitenden Zustand einstellbare elektrische Verbindung mit der dem zweiten Netz zugehörigen elektrischen Leitung vom Rang k elektrisch verbunden ist, was es vermittels einer Ansteuerung mehrerer der einstellbaren elektrischen Verbindungen zum Halten des leitenden Zustands oder zum Übergang in den nicht leitenden Zustand erlaubt, die elektrische Verbindung zwischen zwei benachbarten oder nicht benachbarten elektrischen Leitungen des ersten Netzes sicherzustellen.

2. Verbindungsmatrix nach Anspruch 1, dadurch gekennzeichnet, daß die elektrischen Leitungen des ersten bzw. des zweiten Netzes im wesentlichen parallel zueinander sind, wobei die elektrischen Leitungen des ersten Netzes in einer ersten Richtung orientiert sind und die elektrischen Leitungen des zweiten Netzes in einer zu der ersten Richtung quer verlaufenden zweiten Richtung orientiert sind, wobei jede Leitung des ersten und des zweiten Netzes durch ihren geraden oder ungeraden Rang k, k + r mit $k \in [0, N-1]$ und $r \neq 0 \in [1-N, N-1]$ gekennzeichnet ist, wobei die elektrische Verbindung zwischen zwei benachbarten oder nicht benachbarten Leitungen des ersten Netzes vom Rang k und k + r für die logische Beziehung erhalten wird:

$$Ak \cdot Ak + r$$

für Tk,k UND Tk + r,k ODER
Tk,k + r UND Tk + r,k + r
wobei in dieser logischen Beziehung:
Ak · Ak + r
den logischen Eins-Wert der Verbindung der Leitungen A des ersten Netzes vom Rang k und k + r bezeichnet und bei Bezeichnung des Rangs der Leitungen des ersten und des zweiten Netzes durch den ersten bzw. den zweiten Index:
Tk,k und Tk + r,k + r
den logischen Eins-Wert der die Adresse k,k bzw. k + r,k + r besitzenden permanenten elektrischen Verbindung zwischen der gleichrangigen elektrischen Leitung des ersten und des zweiten Netzes bezeichnen und
Tk,k + r und Tk + r,k
den logischen Eins-Wert des leitenden Zustands der die entsprechenden Adressen k,k + r und k + r,k besitzenden einstellbaren elektrischen Verbindungen zwischen elektrischen Leitungen des ersten und des zweiten Netzes bezeichnen, wobei alle anderen einstellbaren elektrischen Verbindungen, die mit den miteinander verbundenen elektrischen Leitungen vom Rang k,k + r des ersten Netzes verbunden sind, den komplementären logischen Wert des nicht leitenden Zustands besitzen, und zwar für eine Verbindung allein der Leitungen des ersten Netzes vom Rang k,k + r.

3. Verbindungsmatrix nach einem der vorhergehenden Ansprüche,

dadurch gekennzeichnet, daß die elektrischen Leitungen von im wesentlichen geradlinigen Band- oder Mikrostreifenleitungen gebildet sind, wobei die elektrischen Leitungen des ersten Netzes von geradem Rang k = 2j mit einem ihrer Enden mit einer ersten Eingangs/Ausgangsanschlußanordnung verbunden sind und die elektrischen Leitungen des ersten Netzes von ungeradem Rang k = 2j + 1 mit dem anderen ihrer Enden mit einer zweiten Eingangs-/Ausgangsanschlußanordnung verbunden sind.

4. Verbindungsmatrix nach einem der vorhergehenden Ansprüche,
dadurch gekennzeichnet, daß die elektrischen Leitungen von im wesentlichen geradlinigen Band- oder Mikrostreifenleitungen gebildet sind, wobei die elektrischen Leitungen in Gruppen von miteinander verbundenen oder nicht verbundenen Leitungen unterteilt sind, wobei die Leitungen jeder Gruppe mit einer gesonderten Eingangs-/Ausgangsanschlußanordnung verbunden sind.

5. Verbindungsmatrix nach Anspruch 3 oder 4,
dadurch gekennzeichnet, daß die Band- oder Mikrostreifenleitungen auf einem dielektrischen Träger vom Leiterplattentyp, vom Typ eines keramischen Substrats oder eines Substrats aus Silizium gebildet sind.

6. Verbindungsmatrix nach einem der vorhergehenden Ansprüche,
dadurch gekennzeichnet, daß die elektrischen Leitungen des ersten Netzes auf einer ersten Seite des Trägers ausgebildet sind und die elektrischen Leitungen des zweiten Netzes auf einer zweiten Seite des Trägers ausgebildet sind, wobei die permanenten elektrischen Verbindungen von mit einer Metallisierung versehenen Durchgangslöchern gebildet sind und die einstellbaren elektrischen Verbindungen von elektrischen Schmelzverbindungen gebildet sind, bei denen die Einsteuerung in den nicht leitenden Zustand durch Zufuhr eines Stroms mit einer Stärke erfolgt, die größer als ein festgelegter Schwellenwert ist.

7. Verbindungsmatrix nach einem der vorhergehenden Ansprüche,
dadurch gekennzeichnet, daß die elektrischen Leitungen des ersten und des zweiten Netzes auf ein und derselben Seite des Trägers ausgebildet sind, wobei die elektrischen Leitungen des ersten und des zweiten Netzes durch eine Schicht eines elektrisch isolierenden Materials getrennt sind, wobei die permanenten elektrischen Verbindungen von mit einer Metallisierung versehenen Durchgangslöchern gebildet sind und die einstellbaren elektrischen Verbindungen von elektrischen Schmelzverbindungen gebildet sind, bei denen die Einsteuerung in den nicht leitenden Zustand durch Zufuhr eines Stroms mit einer Stärke erfolgt, die größer als ein festgelegter Schwellenwert ist.

8. Verbindungsmatrix nach einem der Ansprüche 6 oder 7,
dadurch gekennzeichnet, daß die elektrischen Schmelzverbindungen von einem elektrischen Schmelzelement oder von zwei gegensinnig parallel geschalteten Dioden gebildet sind.

9. Verbindungsmatrix nach einem der vorhergehenden Ansprüche,
dadurch gekennzeichnet, daß bei einem ersten und einem zweiten Netz mit jeweils N gesonderten elektrischen Leitungen die Zahl der einstellbaren elektrischen Verbindungen optimiert und gleich $N_C = N(N-1)/2$ ist, was die Herstellung jeder Verbindung zwischen zwei benachbarten oder nicht benachbarten elektrischen Leitungen des ersten Netzes erlaubt.

10. Verbindungsmatrix nach Anspruch 9,
dadurch gekennzeichnet, daß das erste und das zweite Netz von gesonderten elektrischen Leitungen jeweils durch die Menge der permanenten elektrischen Verbindungen vom Rang k begrenzt sind, wobei das erste und das zweite Netz auf ein und derselben Seite der von der Menge der permanenten elektrischen Verbindungen gebildeten Grenzlinie verlaufen.

11. Verbindungsmatrix nach Anspruch 9,
dadurch gekennzeichnet, daß das erste und das zweite Netz von gesonderten elektrischen Leitungen beidseits der von der Menge der permanenten elektrischen Verbindungen gebildeten Grenze verlaufen, wobei eine dem ersten Netz zugehörige elektrische Leitung vom Rang q ≠ k durch eine in den leitenden oder den nicht leitenden Zustand einstellbare elektrische Verbindung mit der dem zweiten Netz zugehörigen Leitung vom Rang k elektrisch verbunden ist, wenn die elektrische Leitung des zweiten Netzes vom Rang q ≠ k nicht durch eine in den leitenden oder den nicht leitenden Zustand einstellbare elektrische Verbindung mit der dem ersten Netz zugehörigen Leitung vom Rang k elektrisch verbunden ist, und umgekehrt, was die Abstandsoptimierung bei der Anordnung der in den leitenden oder den nicht leitenden Zustand einstellbaren elektrischen Verbindungen im Hinblick auf eine lokale Minimierung der Erwärmung der Verbindungsmatrix bei der Konfigurierung der Verbindungsmatrix durch Programmieren erlaubt.

12. Verbindungsmatrix nach einem der Ansprüche 5 bis 11,

dadurch gekennzeichnet, daß die in den leitenden oder den nicht leitenden Zustand einstellbaren elektrischen Verbindungen der von den Schmelzelementen, den leitenden Tinten und den gegensinnig parallel geschalteten Dioden mit positiver oder negativer Logik gebildeten Gruppe angehören.

13. Verbindungsmatrix nach Anspruch 12,
dadurch gekennzeichnet, daß die Verbindungsmatrix in Form einer integrierten Schaltung realisiert ist, wobei die in den leitenden oder den nicht leitenden Zustand einstellbaren elektrischen Verbindungen gebildet sind von:

- einem ersten und einem zweiten Schmelzelement, die zwischen einer elektrischen Leitung des ersten und des zweiten Netzes in Reihe miteinander verbunden sind, und
- einem Anschluß zum Anlegen eines Konfigurierungssignals zur Konfigurierung durch Programmieren, wobei der Anschluß mit dem Punkt in der Mitte der Verbindung des ersten mit dem zweiten Schmelzelement verbunden ist.

14. Verbindungsmatrix nach Anspruch 13,
dadurch gekennzeichnet, daß der Anschluß unter Zwischenschaltung einer Diode mit dem mittleren Punkt verbunden ist.

15. Verfahren zur programmierten Konfigurierung einer konfigurierbaren Verbindungsmatrix nach einem der Ansprüche 1 bis 14,
dadurch gekennzeichnet, daß es bei einer Matrix mit N x N elektrischen Leitungen, die das erste und das zweite Netz bilden, umfaßt:

a) Anlegen eines ersten elektrischen Programmierungspotentials mit einem festgelegten Wert an eine Q elektrische Leitungen des ersten Netzes umfassende erste Anfangsmenge,
b) Anlegen eines zweiten elektrischen Programmierungspotentials mit einem festgelegten Wert an eine P elektrische Leitungen des ersten Netzes umfassende zweite Anfangsmenge, was es erlaubt, jede die elektrische Verbindung zwischen zwei elektrischen Leitungen der ersten Anfangsmenge sicherstellende, einstellbare elektrische Verbindung der Adresse k im zweiten Netz im anfänglichen leitenden Zustand zu halten und jede die elektrische Verbindung zwischen einer elektrischen Leitung der ersten und der zweiten Anfangsmenge sicherstellende, einstellbare elektrische Verbindung der Adresse k im zweiten Netz in den nicht leitenden Zustand zu versetzen, und
c) Wiederholen der Operationen a) und b) an aufeinanderfolgenden Untermengen der ersten und zweiten Anfangsmenge, um eine endgültige Konfiguration zu erhalten.

16. Verfahren nach Anspruch 15,
dadurch gekennzeichnet, daß bei einer optimierten Anzahl einstellbarer elektrischer Verbindungen von $N_C = N(N-1)/2$ die Zahl der in der ersten Anfangsmenge enthaltenen einstellbaren elektrischen Verbindungen gleich $N_{CQ} = Q(Q-1)/2$ ist, die Zahl der in der zweiten Anfangsmenge enthaltenen einstellbaren elektrischen Verbindungen gleich $N_{CP} = P(P-1)/2$ ist und die Zahl der die Verbindung zwischen den elektrischen Leitungen der ersten und der zweiten Anfangsmenge sicherstellenden, einstellbaren elektrischen Verbindungen gleich $N_{CQP} = Q(N-Q)$ ist und daß das Verfahren umfaßt:

d) Wählen der die minimale Anzahl elektrischer Leitungen umfassenden Menge elektrischer Leitungen des ersten Netzes als erste Anfangsmenge und
e) Wählen der zu der ersten Anfangsmenge komplementären Menge aus der von der Gesamtheit der elektrischen Leitungen des ersten Netzes gebildeten Menge als zweite Anfangsmenge, was es erlaubt, die Zahl der der Konfigurierungsoperation unterzogenen einstellbaren elektrischen Verbindungen zu optimieren.

17. Einrichtung zur programmierten Konfigurierung einer Verbindungsmatrix nach einem der vorhergehenden Ansprüche 1 bis 14,
dadurch gekennzeichnet, daß sie zumindest umfaßt:

- Generatormittel zum Erzeugen von mindestens zwei unterschiedlichen Programmierungspotentialen,
- Verbindungsmittel zum selektiven Miteinanderverbinden elektrischer Leitungen des ersten Netzes der Verbindungsmatrix entsprechend einer ersten und einer zweiten Anfangsmenge, wobei die erste und die zweite Anfangsmenge jeweils von elektrisch untereinander verbundenen elektrischen Leitungen gebildet sind, wobei die elektrischen Leitungen der ersten Anfangsmenge von den elektrischen Leitungen der zweiten Anfangsmenge elektrisch isoliert sind, und
- Mittel zum Anlegen der unterschiedlichen Programmierungspotentiale an die elektrischen Leitungen der ersten bzw. der zweiten Anfangsmenge.

18. Einrichtung nach Anspruch 17,
dadurch gekennzeichnet, daß bei einer Verbindungsmatrix, bei der die in den leitenden oder den nicht leitenden Zustand elektrisch einstellbaren Verbindungen von zwei in Kaskade angeordneten, an einem Anschluß in ihrem in der Mitte gelegenen Punkt verbundenen Schmelzelementen gebildet sind, die Mittel zum selektiven Miteinanderverbinden sowie die Mittel zum Anlegen der Programmierungspotentiale von einem Schieberegister mit N (N-1)/2 programmierbaren Ausgängen gebildet sind, wobei jeder Ausgang mit dem Anschluß zum Anlegen eines Programmierungspotentials verbunden ist, wobei jeder Ausgang des Schieberegisters so programmiert ist, daß er das eine oder das andere der Programmierungspotentiale bereitstellt.

**Claims**

1. Electrically configurable connection matrix between lines of at least one input/output port with N pins, characterized in that it comprises:

   - a dielectric support, and on this support,
   - a plurality of N distinct electrical lines forming a first network, each electrical line of this first network being connected to a pin of the input/output port, and
   - a plurality of N distinct electrical lines forming a second network, distinct from the first network, each electrical line of rank k, $k \in [0, N-1]$ of the first network being electrically connected by a permanent electrical connection to the electrical line of like rank k belonging to the second network and each electrical line of rank $q \neq k$ belonging to the first network being electrically connected by a configurable electrical connection in the on or off state to the electrical line of rank k belonging to the second network, thus making it possible, through control of maintenance of the on state or of passage to the off state of a plurality of the said configurable electrical connections, to provide for the electrical link between two adjacent or non-adjacent electrical lines of the first network.

2. Connection matrix according to Claim 1, characterized in that the electrical lines of the first respectively of the second network are substantially parallel to one another, the electrical lines of the first network being oriented in a first direction and the electrical lines of the second network being oriented in a second direction, transverse to the first, each line of the first and of the second network being labeled by its rank k, k+r even or odd, with $k \in [0, N-1]$ and $r \neq 0 \in [1-N, N-1]$, electrical interconnection between two adjacent or non-adjacent lines of rank k and k+r of the first network being obtained for the logic relation:

$$Ak \cdot Ak+r$$

if Tk,k AND Tk+r,k OR
   Tk,k+r AND Tk+r, k+r
a logic relation in which:
Ak . Ak+r
   denotes the true logic value of interconnection of the lines A of rank k respectively k+r of the first network, and, the first respectively the second index denoting the rank of the lines of the first respectively of the second network:
Tk,k and Tk+r,k+r
   denotes the true logic value of the permanent electrical connection with address k, k respectively k+r, k+r between electrical line of like rank of the first and of the second network,
Tk, k+r and Tk+r,k
   denotes the true logic value of the on state of the configurable electrical connections with corresponding addresses k,k+r and k+r,k between electrical lines of the first respectively of the second network, all the other configurable electrical connections connected to the interconnected electrical lines of rank k,k+r of the first network being at the complemented logic value of the off state, for an interconnection of the said only lines of rank k,k+r of the first network.

3. Connection matrix according to one of the preceding claims, characterized in that the said electrical lines are formed by substantially rectilinear striplines or microstrips, the electrical lines of even rank $k = 2j$ of the first network being linked at one of their ends to a first input/output port and the electrical lines of odd rank $k = 2j+1$ of the first network being linked at the other of their ends to a second input/output port.

4. Connection matrix according to one of the preceding claims, characterized in that the said electrical lines are formed by substantially rectilinear striplines or microstrips, the electrical lines being subdivided into groups of interconnected or non-interconnected lines, the lines of each group being connected to a distinct input/output port.

5. Connection matrix according to Claim 3 or 4, characterized in that the said striplines or microstrips are formed on a dielectric support of the printed circuit board, ceramic substrate or silicon type.

6. Connection matrix according to one of the preceding claims, characterized in that the said electrical lines of the first network are formed on a first face of the support and the electrical lines of the second network are formed on a second face of the support, the permanent electrical connections being formed by through-holes furnished with a metallization and the configurable electrical connections being formed by fusible electrial links for which switching to the off state is obtained on energizing with a current of strength greater than a specified threshold value.

7. Connection matrix according to one of the preceding claims, characterized in that the electrical lines of the first and of the second network are formed on a same face of the support, the electrical lines of the first respectively of the second network being separated by a layer of electrically insulating material, the permanent electrical connections being formed by through-holes furnished with a metallization and the configurable electrical connections being formed by fusible electrical links for which switching to the off state is obtained on energizing with a current of strength greater than a specified threshold value.

8. Connection matrix according to one of Claims 6 or 7, characterized in that the said electrical links are formed by an electric fuse or two diodes mounted head to tail.

9. Connection matrix according to one of the preceding claims, characterized in that, for a first and a second network each comprising N distinct electrical lines, the number of configurable electrical connections is optimized and equal to $N_c = N(N-1)/2$, thus allowing the establishment of any link between two adjacent or non-adjacent electrical lines of the first network.

10. Connection matrix according to Claim 9, characterized in that the first and the second network of distinct electrical lines are each limited by the set of permanent electrical connections of rank k, the said first and second networks extending on one and the same side of the limit line formed by the set of permanent electrical connections.

11. Connection matrix according to Claim 9, characterized in that the first and second network of distinct electrical lines extend on either side of the limit formed by the set of permanent electrical connections, an electrical line of rank q≠k belonging to the first network being electrically connected by a configurable electrical connection in the on or off state to the line of rank k belonging to the second network if the electrical line of rank q≠k of the second network is not electrically connected by a configurable electrical connection in the on or off state to the line of rank k belonging to the first network, and vice versa, thus allowing optimization of the spacing of the layout of the configurable electrical connections in the on or off state with a view to locally minimizing the heating of the connection matrix during configuration of the connection matrix by programming.

12. Connection matrix according to one of Claims 5 to 11, characterized in that the said configurable electrical connections in the on or off state belong to the group formed by fuses, conductive inks, head-to-tail mounted diodes, under positive or negative logic.

13. Connection matrix according to Claim 12, characterized in that, with the said connection matrix being embodied in the form of an integrated circuit, the said configurable electrical connections in the on or off state are formed by:

- a first and a second fusible element interconnected in series between an electrical line of the first and of the second network,
- a terminal for applying a signal for configuration by programming, the said terminal being electrically linked to the midpoint of interconnection of the first and of the second fusible element.

14. Connection matrix according to Claim 13, characterized in that the said terminal is linked to the midpoint by way of a diode.

15. Process for programmed configuration of a configurable connection matrix according to one of Claims 1 to 14, characterized in that, for a matrix containing NxN electrical lines constituting the first and the second network, this consists in:

a)- applying to a first starting set containing Q electrical lines of the first network, a first programming electrical potential of specified value;
b)- applying to a second starting set containing P electrical lines of the first network, a second programming electrical potential of specified value, this making it possible to maintain in the initial on state every configurable electrical connection with address k in the second network ensuring electrical connection between two electrical lines of the first starting set, and to place in the off state every configurable electrical connection with address k in the second network ensuring electrical connection between an electrical line of the first and of the second starting set;
c)- repeating operations a) and b) on successive subsets of the first and second starting sets, to obtain a final configuration.

16. Process according to Claim 15, characterized in that, for an optimized number of configurable electrical connections $N_C = N(N-1)/2$, the number of configurable electrical connections contained in the first starting set being equal to $N_{CQ} = Q(Q-1)/2$, the number of configurable electrical connections contained in the second starting set being equal to $N_{CP} = P(P-1)/2$ and the number of configurable electrical connections ensuring the link between the electrical lines of the first and of the second starting set being equal to $N_{CQP} = Q(N-Q)$, the said process consists in:

    d)- choosing as first starting set the set of electrical lines of the first network containing the minimum number of electrical lines;

    e)- choosing as second starting set the set complementary to the first starting set, over the set formed by the totality of the electrical lines of the first network, thus allowing optimization of the number of configurable electrical connections subjected to the configuration operation.

17. Device for programmed configuration of a connection matrix according to one of the preceding Claims 1 to 14, characterized in that it includes at least:

- means generating at least two distinct programming potentials;
- means of selective interconnection of the electrical lines of the first network of the said connection matrix according to a first and a second starting set, the first respectively the second starting set each consisting of electrical lines electrically connected together, the electrical lines of the first starting set being electrically insulated from the electrical lines of the second starting set;
- means of applying the said distinct programming potentials to the electrical lines of the first respectively of the second starting set.

18. Device according to Claim 17, characterized in that, for a connection matrix in which the configurable electrical connections in the on or off state are formed by two cascaded fusible elements joined to a terminal at their midpoint, the said means of selective interconnection and of applying the programming potentials consist of a shift register with $N(N-1)/2$ programmable outputs, each output being interconnected to the said terminal for applying a programming potential, each output of the shift register being programmed in order to deliver one or other of the programming potentials.

# FIG.1.

# FIG.2a.

FIG.3a.

FIG.3b.

# FIG.3c.

# FIG.3d.

EP 0 678 948 B1

FIG.4

FIG.5.

23

FIG.6a.

FIG.6b.

FIG.6c.

FIG.6d.

# FIG. 7a.

VP1 – VP2

VP2 ⊙ I_F VP1

1er RÉSEAU { 2ème ENSEMBLE DE DÉPART {

A1₁
L2
A2 2k+1

0  B1
L1
2k  B2
Bn

1er ENSEMBLE DE DÉPART

2ème RÉSEAU

# FIG.7b.

A1 1
A2 2k+1

0  B1
2k
Bn

# FIG.7c.

2ème RÉSEAU

VP1
L2
VP2

1er ENSEMBLE DE DÉPART

2ème ENSEMBLE DE DÉPART

1er RÉSEAU

FIG. 8a.

FIG. 8b.